# EUROPEAN PATENT SPECIFICATION

(11) **EP 1 917 340 B1**
(45) Date of publication and mention of the grant of the patent: **17.12.2008**
(21) Application number: 06791636.1
(22) Date of filing: 21.08.2006
(51) Int. Cl.: C11D 11/00, H05K 3/26, G03F 7/42, H01L 21/306, C11D 7/32, C11D 7/26, C11D 7/50

(54) **METHOD FOR REMOVING IONIC CONTAMINANTS FROM THE SURFACE OF A WORKPIECE**
VERFAHREN ZUR ENTFERNUNG IONISCHER VERUNREINIGUNGEN VON DER OBERFLÄCHE EINES WERKSTÜCKS
PROCÉDÉ POUR ÉLIMINER DES CONTAMINANTS IONIQUES DE LA SURFACE D'UNE PIÈCE DE FABRICATION

(30) Priority: 31.08.2005 DE 102005041533
(43) Date of publication of application: 07.05.2008
(73) Proprietor: ATOTECH Deutschland GmbH, 10553 Berlin (DE)
(72) Inventor: BECK, Thomas, 10559 Berlin (DE); SCHREIER, Hans-Jürgen, 16727 Velten (DE); STEINBERGER, Gerhard, 16562 Hohen Neuendorf-Bergfelde (DE); KUBITZA, Irene, 10783 Berlin (DE)
(74) Representative: Patentanwälte Bressel und Partner
(86) International application number: PCT/EP2006/008315
(87) International publication number: WO 2007/025675

(56) References cited:
- EP-A2- 1 106 166
- EP-A2- 1 519 234
- DE-A1- 3 836 369
- US-A- 5 456 760
- US-A1- 2004 023 834

## Description

The invention relates to a method for removing ionic contaminants from the surface of a workpiece having a solder resist mask and a surface top layer. The method preferably serve to produce electric circuit carriers, more specifically to produce printed circuit boards, in particular to produce contacts on circuit carriers, such as edge connector contacts and push button contacts on printed circuit boards.

During manufacturing of electric circuit carriers, organic and/or metallic layers are applied onto the copper surfaces of the base material. These layers may perform different functions. The organic layers may for example be used to structure the copper surfaces in the subsequent processes. For this purpose, photoresists are applied onto the copper surfaces so as to completely cover them. Thereafter, the layers may be partially exposed to light using a special photomask which images the desired line structures on the photoresist. Thereafter, the imaged structures are developed with corresponding chemicals. Depending on the type of photoresist, which may be negative or positive, either the areas that have been exposed to light or those that have not are removed due to developing so that areas of the copper layer located there beneath are exposed. These areas may then be selectively etched or plated with copper or other metals using an electroless, a chemical or an electrochemical method.

If the metal layers are partially etched or deposited as described, the circuit carriers obtained have certain line structures. To build up complex structures, the method steps may be repeated. Individual layers are compacted together to form multilayer circuits.

In order to allow for electronic component mounting on the circuit carriers provided with the line structures, additional layers such as gold, silver, tin, nickel layers, are for example deposited next, using an electroless, a chemical or an electrochemical method, to form the surface top layer while using a solder resist. On the one side, these surface top layers serve to form solderable surface areas needed to mount the components. On the other side, gold surface areas are also suited for bonding housed and unhoused semiconductor components:

These surface top layers moreover also serve as protective layers intended to prevent the copper surfaces from oxidizing and to preserve their solderability. These top layers are necessary since the manufacturing of the circuit carrier and its further processing, *e.g*., the mounting of components thereon, usually will not take place on the same manufacturing site, so that further processing will only occur at a later stage.

Gold and silver layers are for example also formed as surface top layers for manufacturing detachable electric contacts, for example plug connectors for plugging the circuit carrier by inserting them into contact sockets and contact areas for manufacturing push buttons.

Once the circuit carrier has been completed, *i*.*e*., after the surface top layer has been applied, the circuit carriers are rinsed thoroughly once more, before they are dried and then stored or subjected to further processing, in order to clean them from any ionic contaminants originating from the various method steps and more specifically being caused by the deposition method for producing the surface top layers.

Tests are carried out to control cleanliness and in order to determine the concentration of surface contamination of the circuit carrier. In these standardized tests (for example the test method IPC-TM-650, developed by Technical Committees of IPC/Association Connecting Electronic Industries - Detection and Measurement of Ionizable Surface Contaminants by Resistivity of Solvent Extract (ROSE)), any still adhering ionic contaminants are extracted for example manually from the surface of the circuit carrier using a water (deionized) / 2-propanol mixture. The extract is collected in its totality and its electric resistance or its conductivity is determined. The concentration of the ionic contaminants in units of a standard NaCl solution can be determined from a (straight) calibration line obtained from plotting the values of the resistivity or of the electric conductivity, respectively, as a function of the concentration values of diverse standard NaCl solutions. Based on the volume utilized and on the size of the circuit carrier's surface, one then obtains the ionic contamination for each area in µg/cm² or µg/inch².

Thorough cleaning of the surface of the circuit carriers is mainly needed to avoid the risk of contact corrosion of the conductor structures caused by the ionic contaminants. This risk increases in particular on the background of increasing miniaturization of circuit carriers or of increasing complexity of the line structures per surface area on the circuit carriers. This is due to the fact that, with the contamination values on the surface of the circuit carriers remaining the same, the more complex conductor structures meet ionic contaminants statistically more often, with the risk of contact corrosion strongly increasing as a result thereof. Also, finer conductor structures are much more vulnerable with regard to their functionality, *e.g*., with regard to their impedance behaviour, than larger ones, so that, due to the presence of contaminants, such finer conductor structures often become useless, for example for component mounting. Moreover, bridging ionic contaminants may also produce leakage current or even short circuits between adjacent conductor structures, which may adversely affect or even destroy the circuit carrier and the components located thereon through impedance fluctuations in the conductors.

In practice, it has been found that, in particular in the case of circuit carriers with solder resist masks and in spite of repeating the rinsing steps, the solutions and methods utilized do not suffice or are deficient in removing the ionic contaminants to be found on the surface after deposition of the surface top layers. As a result, the surfaces have undesirable high concentrations of ionic contaminants even after cleaning, these contaminants leading in further processing to the problems mentioned herein above.

A detergent for cleaning components and units for radioelectronic equipment is disclosed in Chem. Abstr. 95:221722 relating to SU 859 433 A1. This detergent contains, *i.a*., triethanolamine and ethanol.

Further Chem. Abstr. 130:155316 relating to CN 1124285 A discloses a cleaning agent for semiconductor industry, the agent containing, *i.a*., ethanolamine, ethanol and water.

Further US 6,566,315 B2 discloses formulations including a 1,3-dicarbonyl compound chelating agent and copper inhibiting agents for stripping residues from semiconductor substrates containing copper structures. These formulations contain, *i.a*., triethanolamine, water and ethylene glycol.

Further WO 99/16855 A1 discloses cleaning compositions and methods for cleaning resin and polymeric materials used in manufacture, more specifically in the manufacture of optical lenses. The compositions contain ethanolamines and alcohols.

Further US 6,121,217 A discloses alkanolamine semiconductor process residue removal compositions and a process. The compositions contain an alkanolamine and a polar solvent like water or a polar organic solvent like ethylene glycol or ethers thereof.

Chem. Abstr. 137:187413 relating to CN 1316495 A discloses a water-based detergent for cleaning printed circuit boards. The detergent contains, *i.a*., alkanol amine and ethanol or another aliphatic alcohol.

Further Chem. Abstr. 137:187414 relating to CN 1316417 A discloses a liquid detergent for cleaning metallic parts or semiconductors. This detergent contains, *i.a*., alkanolamine, a C16-C18 aliphatic alcohol and ethylene glycol.

Further DE 199 45 221 A1 discloses a washing agent for rollers, this agent containing, *i.a*., a monovalent alcohol and an amino alcohol, *e.g*., 2-propanol and 2-amino-2-(methyl-1-propanol).

Further DE 195 18 990 A1 discloses an agent for cleaning ink jet heads and the nozzles thereof. This agent contains, *i.a*., D.I. water, triethanolamine and ethylene glycol.

The problem underlying the present invention is to avoid the known disadvantages of the solutions and methods for cleaning the surface of circuit carriers having copper structures covered partly with a solder resist mask and partly with conductive surface top layers.

It is therefore an object of the invention to find a chemical solution for removing ionic contaminants from the surface of a workpiece having a solder resist mask and a surface top layer.

It is a further object of the invention to find a chemical solution for at least strongly and reliably reducing ionic contaminants from the surface of such a workpiece.

It is a further object of the invention to find a chemical solution for removing ionic contaminants from the surface of such a workpiece which is cost efficient and easy to manipulate.

It is still another object of the present invention to find a method of removing ionic contaminants from the surface of such a workpiece.

It is still another object of the present invention to find a method of removing ionic contaminants from the surface of such a workpiece which is cost efficient and easy to perform.

The solution to these objects is achieved by the method of removing ionic contaminants from the surface of a workpiece having a solder resist mask and a surface top layer of claim 1. Preferred embodiments of the invention are recited in the dependent claims.

The invention serves to remove ionic contaminants from the surface of a workpiece, more specifically after a conductive surface top layer has been deposited on the workpiece, more precisely on copper surface areas or copper structures that are not covered with a solder resist mask on the surface of the workpiece, to form solderable and/or bondable areas on such surface areas, as well as to manufacture contacts such as edge connector contacts and push button contacts.

The solution of the invention is a method of removing ionic contaminants from the surface of a workpiece, said surface having a solder resist mask and a surface top layer, the method comprising treating the workpiece with an aqueous solution, the solution containing:
a) at least one first compound selected from the group comprising ethanolamine compounds and the salts thereof;
b) at least one second compound selected from the group comprising alcoholic solvents; and
c) at least one third compound selected from the group comprising guanidine compounds and the salts thereof.

The method is preferably used for producing electric circuit carriers such as printed circuit boards and can be used in vertical and/or horizontal lines. The method of the invention can more specifically be used to be applied on circuit carriers for producing contacts such as edge connector contacts and push button contacts.

The method of the invention is simple, easy to perform and cost-efficient. It serves to remove ionic contaminants from the surface of a workpiece having a solder resist mask and a surface top layer being coated on copper structures, the method comprising treating the workpiece with the aqueous solution of the invention once the top layer has been deposited. The workpieces preferably include electric circuit carriers such as printed circuit boards having solderable and/or bondable areas as well as contacts such as edge connector contacts and push button contacts.

With the method of the invention the problems arising from using the known means can be eliminated. The strongly cleaned surfaces required in particular as a result of increasing miniaturization are made possible by the aqueous solution of the invention.

It has been found that the contamination values can be strongly reduced, using the aqueous solution of the invention. Depending on the material used for the solder resist mask, the amount of ionic contaminants on the surface of the workpieces can be reduced by 50 to 87 % over conventional methods. It is found that the main problems in removing ionic contaminants from the surface of workpieces occur when the solder resist masks were not properly cured or had been affected by the processes for depositing the top layers. In these cases, an important improvement in cleanliness over the conventional solutions and methods has been achieved using the present invention. Comparative tests with printed circuit boards with and without solder resist masks could also evidence that the ionic contaminants do not originate from the (metal) deposition baths used for forming the surface (metal) top layers. It could be shown that the ionic contaminants also bleed out from the solder resist masks that are attacked by the aggressive bath chemicals of the deposition baths.

Without limiting the general idea of the invention, the cleaning effect of the aqueous solution used in the invention is possibly due to the fact that the solder resist mask is slightly dissolved by the aqueous solution of the invention if the method of the invention is performed, this causing the ionic contaminants to be released from the solder resist mask and to be absorbed or bound in the aqueous solution. Without the aqueous solution, the contaminants would otherwise be released from the solder resist mask at a later stage only, thus leading at a later point of time to the occurrence of the undesirable contaminations on the surface of the workpiece.

The quality of cleanliness of the surface of the workpiece is controlled, as already described above, by standardized tests. These tests are preferably carried out in accordance with the test methods manual IPC-TM-650, which is incorporated by reference herein (test method: IPC-TM-650 under Item No 2.3.25, developed by Technical Committees of IPC/Association Connecting Electronic Industries - Detection and Measurement of Ionizable Surface Contaminants by Resistivity of Solvent Extract (ROSE)). In this test, a printed circuit board is preferably immersed into an alcohol/water mixture composed of 75 % (or 50 %) of 2-propanol and 25 % (or 50 %) of D.I. water (deionized). The water should have a resistance of more than 1 MΩ. 2-propanol should have the "Electronic Grade" purity. Further, no glass instruments should be used.

The ionic contaminants are flushed from the surface of the printed circuit board using the alcohol/water mixture. The mixture is carefully collected. The ionic contaminants on the printed circuit board (and/or contained in the solder resist mask), which are extracted by the mixture, cause the electric conductivity of the alcohol/water mixture to increase. Conductivity is determined during the entire measurement (30 minutes) and expressed in µg/cm² or µg/inch² NaCl equivalent, with the NaCl equivalent being determined by a (straight) calibration line in which the values of certain standard concentrations of NaCl solutions are plotted against the values of corresponding electric conductivities.

The aqueous solution used in the invention preferably has a pH of more than 7. A pH-range of more than 9 is particularly preferred. A pH in a range in excess of 11 is most preferred.

In order to achieve the cleaning effect described by removing ionic contaminants, the aqueous solution used in the invention contains the at least one first compound (ethanolamine compound and/or the salt thereof) preferably in a concentration ranging from 5 to 25 g/l, with a concentration of about 14 g/l being particularly preferred (all first compounds taken together). Monoethanolamine is preferably added as an ethanolamine compound.

The concentration of the alcoholic solvent preferably ranges from 0.5 to 5 g/l, with a concentration of about 1 g/l being particularly preferred (all alcoholic solvents taken together). Low molecular alcoholic solvents such as methanol, ethanol, n-butanol, iso-butanol or tert-butanol are preferably added. 2-propanol is particularly preferred.

In the aqueous solution used in the invention, the guanidine compounds and/or the salts thereof probably act as chelate complexes with respect to the ionic contaminants with direct coordination of the metal ions/metals to the nitrogen-containing structure fragments of the guanidine. This effect is possibly enhanced by the other substances of the aqueous solution of the invention.

The concentration of the at least one third compound (guanidine compounds and/or of the salts thereof) preferably ranges from 0.5 to 5 g/I, with a concentration of about 1.5 g/I being particularly preferred (all third compounds taken together). The guanidine compound is preferably added as a salt (guanidinium compound). Guanidinium carbonate, guanidinium phosphate or guanidinium sulfate are particularly preferred. The oxygen-containing salt anions of the guanidinium compounds possibly enhance the efficiency of the chelate complex through electron effects.

In a preferred composition, the aqueous solution of the invention contains 1.5 g of guanidinium carbonate, 14 g of monoethanolamine (850 ml/l) and 1 g of 2-propanol, based on one liter of deionized water. A pH of 9 - 12 is particularly preferred for the aqueous solution.

For treatment, the aqueous solution used in the invention can be heated in order to improve the cleaning effect for it has been found that the ionic contaminants can thus be removed more efficiently. During treatment of the workpiece, the aqueous solution of the invention preferably has a temperature ranging from 50 - 70°C. A temperature of about 60°C is particularly preferred.

The workpiece is preferably treated with the aqueous solution for a duration of 0.5 to 2 min. One minute is particularly preferred.

The concentration of the ionic contaminants may be further reduced if the workpiece is rinsed with deionized water at least once prior to being treated with the aqueous solution used in the invention.

As an alternative, or in addition thereto, the workpiece can be rinsed with deionized water at least once after having been treated with the aqueous solution used in the invention.

To improve shelf life of the workpiece, more specifically to preserve bondability and solderability of the areas of the workpiece coated with the surface top layer, said workpiece can be dried in a dryer after having been rinsed with deionized water, this also reducing the risk of corrosion.

A particularly good cleaning effect with correspondingly low contamination values is observed in particular when the solder resist masks used are made from organic compounds such as epoxy resin acrylates, *e.g*., the masks Taiyo PSR 4000 MH, Taiyo PSR 4000 MP, Taiyo 4000 AUS 5, Taiyo 4000 GHP 3. These are additionally filled with inorganic materials such as SiO₂ or Al₂O₃ for example.

The deposited conductive surface top layers are preferably selected from the group comprising bismuth, tin, gold, silver, palladium and nickel or the alloys thereof.

The deposited conductive surface top layers may serve for example as bondable and solderable layers or as electric contacts/contact layers for push buttons or edge connector contacts. The surface top layers may be deposited using for example an electrochemical, an electroless or a chemical method. Chemical deposition through charge exchange reaction between the metals is preferred, with a metal (here copper or a copper alloy) dissolving partially while the metal dissolved is deposited. A surface top layer obtained through chemical deposition of immersion silver or immersion tin (deposited through charge exchange reaction) is thereby particularly preferred. Electroless deposition of *e.g*., nickel with immersion gold being applied thereon is also preferred.

To form an electroless nickel-gold layer with an electroless method, the copper surface is first treated with a bath for depositing palladium nuclei onto the surface. Next, in another bath containing nickel ions, for example in the form of a sulfate salt, as well as a reducing agent, metal plating can be performed. The reducing agent usually utilized is a hypophosphite salt, for example the sodium salt, or the corresponding acid. In this case, a nickel/phosphorus layer forms. If a nickel/boron layer is to be formed, a borane, for example dimethyl amino borane or a hydridoborate such as sodium boron hydride is utilized as the reducing agent. If pure nickel layers are to be deposited, the reducing agent used preferably is hydrazine or a hydrazine derivative. These baths additionally contain complexing agents, more specifically organic carboxylic acids, pH-adjusting agents such as ammonia or acetate, as well as stabilizing agents such as sulfur compounds or lead salts. The gold layer is applied to the nickel layer that has been deposited with an electroless method, preferably in a charge exchange process.

To form a chemical tin layer, the copper surface is contacted with a solution containing tin(II) ions, for example tin(II) sulfate, an acid such as sulfuric acid, as well as a thiourea or a thiourea derivative. The tin layer forms on the copper surface through charge exchange reaction, with the copper dissolving in favour of tin.

To deposit layers of immersion silver, the copper structures on the workpiece can be treated with an acidic solution containing silver ions.

The workpieces can be treated in current dip (immersion) lines. For treating printed circuit boards, it has been found particularly advantageous to utilize what are termed conveyorized lines in which the printed circuit boards are conveyorized through the line on a horizontal conveying path while being contacted with the treatment solutions through appropriate nozzles such as spray or flow nozzles. For this purpose, the printed circuit boards can be held horizontally or vertically or in any other orientation.

The following examples serve to further explain the invention:

For this purpose, printed circuit boards with various solder resist masks covering partially the copper structures on the printed circuit board were treated using various deposition methods for forming surface top layers. Next, the printed circuit boards were treated either with or without the aqueous solution used in the invention. Thereafter, the amount of ionic contaminants formed on the printed circuit boards was determined according to the standardized tests described herein above.

### Example 1:

Printed circuit boards with four different solder resist masks (Taiyo PSR 4000 MH, Taiyo PSR 4000 MP, Taiyo 4000 AUS 5, Taiyo 4000 GHP 3) were treated with a tin deposition method according to Table 1 and a layer of immersion tin of 1 µm thick was applied. The tin deposition bath contained tin(II) methanesulfonate, methane sulfonic acid and thiourea. After deposition, one board of each printed circuit board type was treated in accordance with the invention, and one board not in accordance with the invention (for reference).

The aqueous solution used in the invention had the following composition, based on one liter of deionized water:
1.5 g/l of guanidinium carbonate (purity 98 %)
14 g/l of monoethanolamine (850 ml/l in deionized water)
1 g/l of isopropanol
pH of about 10.5.

Next, the amount of the ionic contaminants on the boards was determined using the standardized test. The results are set forth in Table 2.

The results show that the extent of ionic contamination could be considerably reduced with the treatment method of the invention. The amount of ionic contaminants was reduced by 58 % for MP and 87 % for AUS 5.

### Example 2:

Two printed circuit boards, each one coated with the solder resist mask Taiyo PSR 4000 MP, were treated with a vertically performed method for immersion silver deposition according to Table 3, with a silver layer of 1 µm thick being applied. The silver deposition bath contained silver methanesulfonate and methane sulfonic acid. After deposition, one board of each printed circuit board type was treated in accordance with the invention, and one board not in accordance with the invention (for reference).

Next, the amount of the ionic contaminants on the boards was determined using the standardized test. The results are set forth in Table 4.

The results show that the extent of ionic contamination could be considerably reduced with the treatment method of the invention. The amount of ionic contaminants was reduced by about 63 %.

**Table 1. Process Sequence:**

| **Time [min]** | **Method steps with the cleaning solution used in the invention** | **Method steps (for reference) without the cleaning solution used in the invention** | **Temperature** |
|---|---|---|---|
| 5 | Pro Select SF | Pro Select SF | 40°C |
| 1 | D.I. water | D.I. water | RT |
| 1 | D.I. water | D.I. water | RT |
| 1 | Microtech H | Microtech H | 35°C. |
| 1 | D.I. water | D.I. water | RT |
| 1 | D.I. water | D.I. water | RT |
| 1 | Stannatech Pre Dip | Stannatech Pre Dip | RT |
| 13 | Stannatech V 2000 | Stannatech V 2000 | 70°C |
| 1 | Alkaline rinse | Alkaline rinse | RT |
| 1 | D.I. water | D.I. water | RT |
| 1 | D.I. water | D.I. water | RT |
| 1 | Cleaning solution of the invention | ---- | 60°C |
| 1 | D.I. water | D.I. water | RT |
| 1 | D.I. water | D.I. water | RT |
| 1 | Hot rinse | Hot rinse | 50°C |
| 1 | Hot rinse | Hot rinse | 50°C |
| 20 | Dryer | Dryer | 60°C |

| | | | |
|---|---|---|---|
| D.I. water: Deionized water RT: room temperature | | | |

**Table 2. Results:**

| | Ionic contamination in [µg/cm²] NaCl equivalent | | | |
|---|---|---|---|---|
| Solder resist mask Taiyo PSR 4000 | MH | MP | AUS 5 | GHP 3 |
| **With the cleaning solution used in the invention** | 0.34 | 0.25 | 0.06 | 0.40 |
| Without cleaning solution used in the invention (for reference) | 0.99 | 0.59 | 0.45 | 1.86 |

**Table 3. Process Sequence:**

| **Time [min]** | **Method steps with the cleaning solution used in the invention** | **Method steps (for reference) without the cleaning solution used in the invention** | **Temperature** |
|---|---|---|---|
| 5 | Pro Select SF | Pro Select SF | 40°C |
| 1 | D.I. water | D.I. water | RT |
| 1 | Micro Etch C | Micro Etch C | 35°C |
| 1 | D.I. water | D.I. water | RT |
| 1 | D.I. water | D.I. water | RT |
| 1 | Pre-immersion solution | Pre-immersion solution | RT |
| 1 | Conditioner | Conditioner | RT |
| 1 | D.I. water | D.I. water | RT |
| 1 | D.I. water | D.I. water | RT |
| 1 | Predip | Predip | 40°C |
| 1,5 | Silver | Silver | 50°C |
| 1 | D.I. water | D.I. water | RT |
| 1 | **Cleaning solution of the invention** | --- | 60°C |
| 1 | D.I. water | D.I. water | RT |
| 20 | Dryer . | Dryer | 60°C |

| | | | |
|---|---|---|---|
| D.I. water: Deionized water RT: room temperature | | | |

**Table 4. Results:**

| | Ionic contamination in [µg/cm²] NaCl equivalent | |
|---|---|---|
| | **With the cleaning solution used in the invention** | Without cleaning solution used in the invention (for reference) |
| Solder resist mask Taiyo PSR 4000 MP | 0.10 | 0.27 |

## Claims

1. A method of removing ionic contaminants from the surface of a workpiece, said surface having a solder resist mask and a surface top layer, the method comprising treating the workpiece with an aqueous solution, the solution containing:
a) at least one first compound selected from the group comprising ethanolamine compounds and/or the salts thereof;
b) at least one second compound selected from the group comprising alcoholic solvents; and
c) at least one third compound selected from the group comprising guanidine compounds and/or the salts thereof.

2. The method according to claim 1, wherein said at least one ethanolamine compound is monoethanolamine.

3. The method according to any one of the preceding claims, wherein said at least one alcoholic solvent is selected from the group comprising 2-propanol and n-propanol.

4. The method according to any one of the preceding claims, wherein at least one salt of said guanidine compounds is selected from the group comprising guanidinium carbonate, guanidinium phosphate and guanidinium sulfate.

5. The method according to any one of the preceding claims, wherein the concentration of said at least one first compound ranges from about 5 to about 25 g/l.

6. The method according to any one of the preceding claims, wherein the concentration of said at least one alcoholic solvent ranges from about 0.5 to about 5 g/l.

7. The method according to any one of the preceding claims, wherein the concentration of said at least one third compound ranges from about 0.5 to about 5 g/l.

8. The method according to any one of the preceding claims, wherein the pH of said aqueous solution is in excess of about 7.

9. The method according to any one of the preceding claims, wherein the pH of said aqueous solution is in excess of about 11.

10. The method according to any one of the preceding claims, wherein said method is used in the production of electric circuit carriers in vertical and/or horizontal lines.

11. The method according to any one of claims 1 to 9, wherein said method is used in the production of electric contacts on electric circuit carriers.

12. The method according to any one of the preceding claims, wherein said aqueous solution for removing ionic contaminants has a temperature ranging from about 50 °C to about 70°C.

13. The method according to any one of the preceding claims, wherein said workpiece is treated with said aqueous solution for removing ionic contaminants for a duration of about 0.5 min to about 2 min.

14. The method according to any one of the preceding claims, wherein said solder resist mask is of the Taiyo PSR 4000 MH, Taiyo PSR 4000 MP, Taiyo 4000 AUS 5 or Taiyo 4000 GHP 3 type.

15. The method according to any one of the preceding claims, wherein said surface top layer is made of a metal selected from the group comprising bismuth, tin, gold, silver, palladium and nickel and the alloys thereof.

16. The method according to claim 15, wherein said surface top layer is deposited onto said workpiece surface using a deposition method selected from the group comprising electroless, chemical and electrochemical methods.

17. The method according to any one of the preceding claims, wherein said surface top layer is at least one of a solderable and bondable surface top layer.

18. The method according to any one of the preceding claims, wherein said method further comprises rinsing said workpiece at least once with deionized water before and/or after being subjected to a treatment with said aqueous solution.

## Patentansprüche

1. Verfahren zum Entfernen von ionischen Kontaminationen von der Oberfläche eines Werkstückes, wobei die Oberfläche eine Lötstopmaske sowie eine Oberflächenendschicht aufweist und wobei das Verfahren das Behandeln des Werkstückes mit einer wässrigen Lösung umfasst und die wässrige Lösung folgende Bestandteile enthält:
a) mindestens eine erste Verbindung, ausgewählt aus der Gruppe, umfassend Ethanolamin-Verbindungen und/oder deren Salze;
b) mindestens eine zweite Verbindung, ausgewählt aus der Gruppe, umfassend alkoholische Lösungsmittel; und
c) mindestens eine dritte Verbindung, ausgewählt aus der Gruppe, umfassend Guanidin-Verbindungen und/oder deren Salze.

2. Verfahren nach Anspruch 1, wobei die mindestens eine Ethanolamin-Verbindung Monoethanolamin ist.

3. Verfahren nach einem der vorstehenden Ansprüche, wobei das mindestens eine alkoholische Lösungsmittel ausgewählt ist aus der Gruppe, umfassend 2-Propanol und n-Propanol.

4. Verfahren nach einem der vorstehenden Ansprüche, wobei mindestens ein Salz der Guanidin-Verbindungen ausgewählt ist aus der Gruppe, umfassend Guanidiniumcarbonat, Guanidiniumphosphat und Guanidiniumsulfat.

5. Verfahren nach einem der vorstehenden Ansprüche, wobei die Konzentration der mindestens einen ersten Verbindung in einem Bereich von etwa 5 bis etwa 25 g/l liegt.

6. Verfahren nach einem der vorstehenden Ansprüche, wobei die Konzentration des mindestens einen alkoholischen Lösungsmittels in einem Bereich von etwa 0,5 bis etwa 5 g/l liegt.

7. Verfahren nach einem der vorstehenden Ansprüche, wobei die Konzentration der mindestens einen dritten Verbindung in einem Bereich von etwa 0,5 bis etwa 5 g/l liegt.

8. Verfahren nach einem der vorstehenden Ansprüche, wobei der pH-Wert der wässrigen Lösung größer als etwa 7 ist.

9. Verfahren nach einem der vorstehenden Ansprüche, wobei der pH-Wert der wässrigen Lösung größer als etwa 11 ist.

10. Verfahren nach einem der vorstehenden Ansprüche, wobei das Verfahren bei der Produktion von elektrischen Schaltungsträgern in Vertikal- und/oder Horizontalanlagen angewendet wird.

11. Verfahren nach einem der Ansprüche 1-9, wobei das Verfahren bei der Produktion von elektrischen Kontakten auf elektrischen Schaltungsträgern angewendet wird.

12. Verfahren nach einem der vorstehenden Ansprüche, wobei die wässrige Lösung zum Entfernen von ionischen Kontaminationen eine Temperatur im Bereich von etwa 50°C bis etwa 70°C hat.

13. Verfahren nach einem der vorstehenden Ansprüche, wobei das Werkstück mit der wässrigen Lösung zum Entfernen von ionischen Kontaminationen während einer Dauer von etwa 0,5 min bis etwa 2 min behandelt wird.

14. Verfahren nach einem der vorstehenden Ansprüche, wobei die Lötstopmaske vom Typ Taiyo PSR 4000 MH, Taiyo PSR 4000 MP, Taiyo 4000 AUS 5 oder Taiyo 4000 GHP 3 ist.

15. Verfahren nach einem der vorstehenden Ansprüche, wobei die Oberflächenendschicht aus einem Metall hergestellt ist, das ausgewählt ist aus der Gruppe, umfassend Wismut, Zinn, Gold, Silber, Palladium und Nickel sowie deren Legierungen.

16. Verfahren nach Anspruch 15, wobei die Oberflächenendschicht auf der Werkstückoberfläche unter Anwendung eines Abscheideverfahrens abgeschieden wird, das ausgewählt ist aus der Gruppe, umfassend stromlose, chemische und elektrochemische Verfahren.

17. Verfahren nach einem der vorstehenden Ansprüche, wobei die Oberflächenendschicht mindestens eine lötbare oder bondbare Oberflächenendschicht.

18. Verfahren nach einem der vorstehenden Ansprüche, wobei das Verfahren weiterhin das mindestens einmalige Spülen des Werkstückes mit deionisiertem Wasser vor und/oder nach einer Behandlung mit der wässrigen Lösung umfasst.

## Revendications

1. Procédé d'élimination de contaminants ioniques de la surface d'une pièce, ladite surface ayant un masque de réserve de soudure et une couche supérieure de surface, le procédé comprenant le traitement de la pièce avec une solution aqueuse, la solution contenant :
a) au moins un premier composé choisi dans le groupe constitué de composés d'éthanolamine et/ou leurs sels ;
b) au moins un second composé choisi dans le groupe constitué de solvants alcoolisés ; et
c) au moins un troisième composé choisi dans le groupe comprenant des composés de guanidine et/ou leurs sels.

2. Procédé selon la revendication 1, dans lequel au moins un composé d'éthanolamine est la monoéthanolamine.

3. Procédé selon l'une quelconque des revendications précédentes, dans lequel au moins un solvant alcoolisé est choisi dans le groupe comprenant du 2-propanol et du n-propanol.

4. Procédé selon l'une quelconque des revendications précédentes, dans lequel au moins un sel desdits composés de guanidine est choisi dans le groupe comprenant du carbonate de guanidine, du phosphate de guanidine et du sulfate de guanidine.

5. Procédé selon l'une quelconque des revendications précédentes, dans lequel la concentration dudit au moins un premier composé est comprise entre environ 5 et environ 25 g/l.

6. Procédé selon l'une quelconque des revendications précédentes, dans lequel la concentration dudit au moins un solvant alcoolisé est comprise entre environ 0,5 et environ 5 g/l.

7. Procédé selon l'une quelconque des revendications précédentes, dans lequel la concentration dudit au moins un troisième composé est comprise entre environ 0,5 et environ 5 g/l.

8. Procédé selon l'une quelconque des revendications précédentes, dans lequel le pH de ladite solution aqueuse est supérieur à environ 7.

9. Procédé selon l'une quelconque des revendications précédentes, dans lequel le pH de ladite solution aqueuse est supérieur à environ 11.

10. Procédé selon l'une quelconque des revendications précédentes, dans lequel ledit procédé est utilisé dans la production de supports de circuits électriques dans les lignes verticales et/ou horizontales.

11. Procédé selon l'une quelconque des revendications 1 à 9, dans lequel ledit procédé est utilisé dans la production de contacts électriques sur des supports de circuits électriques.

12. Procédé selon l'une quelconque des revendications précédentes, dans lequel ladite solution aqueuse pour éliminer les contaminants ioniques a une température comprise entre environ 50°C et environ 70°C.

13. Procédé selon l'une quelconque des revendications précédentes, dans lequel ladite pièce est traitée avec ladite solution aqueuse pour éliminer les contaminants ioniques, pendant une durée d'environ 0,5 minute à environ 2 minutes.

14. Procédé selon l'une quelconque des revendications précédentes, dans lequel ledit masque de réserve de soudure est de type Taiyo PSR 4000 MH, Taiyo PSR 4000 MP, Taiyo 4000 AUS 5 ou Taiyo 4000 GHP 3.

15. Procédé selon l'une quelconque des revendications précédentes, dans lequel ladite couche supérieure de surface est faite d'un métal choisi dans le groupe comprenant le bismuth, l'étain, l'or, l'argent, le palladium, et le nickel et des alliages de ceux-ci.

16. Procédé selon la revendication 15, dans lequel ladite couche supérieure de surface est déposée sur ladite surface de pièce en utilisant un procédé de déposition choisi dans le groupe comprenant des procédés chimiques et électrochimiques.

17. Procédé selon l'une quelconque des revendications précédentes, dans lequel ladite couche supérieure de surface est au moins une couche supérieure de surface soudable et liable.

18. Procédé selon l'une quelconque des revendications précédentes, dans lequel ledit procédé comprend en outre le rinçage de ladite pièce au moins une fois avec de l'eau désionisée avant et/ou après soumission à un traitement avec ladite solution aqueuse.
